# EUROPEAN PATENT APPLICATION

(11) **EP 2 284 888 A2**
(43) Date of publication of application: **16.02.2011**
(21) Application number: 10008048.0
(22) Date of filing: 02.08.2010
(51) Int. Cl.: H01L 23/66, H01Q 1/38, H01Q 23/00, H01Q 1/22, H01L 23/498

(54) **Interposer, module and electronics device including the same**

(30) Priority: 07.08.2009 JP 2009184674; 07.06.2010 JP 2010130266
(71) Applicant: Sony Corporation, Tokyo 108-0075 (JP)
(72) Inventor: Akiba, Akira, Tokyo 108-0075 (JP); Mitarai, Shun, Tokyo 108-0075 (JP); Ikeda, Koichi, Tokyo 108-0075 (JP); Morita, Shinya, Tokyo 108-0075 (JP)
(74) Representative: Müller - Hoffmann & Partner

(57) **Abstract**

An interposer with which the manufacturing steps are able to be simplified and which shows superior high frequency characteristics is provided. The interposer includes: a substrate having a front face and a rear face; a wiring that is formed on the front face side of the substrate and is electrically connected to a semiconductor chip; an electric device connected to the wiring; and a concave section that is formed from the rear face side of the substrate in a position corresponding to the electric device.

## Description

### BACKGROUND OF THE INVENTION

1. Field of the Invention

The present invention relates to an interposer for intermediating electric connection and mechanical connection among a plurality of electronic devices with each wiring rule different from each other, a module, and an electronics device including the same.

2. Description of the Related Art

There is a single-digit or more gap between a pad pitch of a semiconductor chip whose miniaturization has been rapidly improved and a pad pitch of a substrate (mount substrate) on which the semiconductor chip is mounted. Such a gap leads to difficulty to reflect high performance obtained by progress of semiconductor technology and performance of a high function chip to a device or a system. For example, the practically used pad pitch of the semiconductor chip has been improved to 50 µm or less, while the pad pitch of the mount substrate (for example, a Print Circuit Board (PCB)) is about 500 µm. It is expected that miniaturization of the pad pitch of the semiconductor chip will be improved according to scaling rule in the future. Meanwhile, miniaturization of the pad pitch of the PCB may be improved relatively slowly.

In the past, as a means for compensating the pad pitch gap and electrically and mechanically bonding the semiconductor chip with the mount substrate, wiring made of gold (Au) or aluminum (Al) has been used. Specifically, the semiconductor chip is die-bonded (mechanically connected) onto an organic substrate having 500 µm class wiring rule, and wiring pads of the organic substrate and the semiconductor chip are wire-connected (electrically connected).

In a signal line, as the carrier frequency is increased, influence of the length becomes increased. For a carrier of a digital circuit, a signal with 400 MHz class clock frequency is used. Meanwhile, for a carrier of a transmitting and receiving circuit, high frequency band (from GHz to millimeter waveband) is used. High frequency has a short wavelength. For example, half-wavelength of 60 GHz is 2.5 mm in vacuum and 1.2 mm on the PCB. In the case where the physical length of a certain signal line is equal to or more than half of the electric length of a carrier frequency, problematic signal resonance phenomenon is shown in the signal line. Thus, in view of securing signal quality, it is desirable that layout is made so that the length of the signal line is smaller than the half of the electric length of the transmission carrier signal. Accordingly, in recent years, a packaging smaller than that of a mounting mode with the use of a wire becomes available. A silicon interposer with which power loss reduction and improved signal quality by short wiring are expected attracts attention, and the technical development thereof has been actively made (for example, Japanese Unexamined Patent Application Publication No. 2008-42904).

The silicon interposer according to Japanese Unexamined Patent Application Publication No. 2008-42904 is composed of a wiring for converting a wiring pitch (including a TSV (Through Silicon Via)) and a cavity (concave section) for the after-mentioned antenna part. The silicon interposer has a structure in which on an interposer substrate, an antenna pattern formed in another silicon substrate (upper silicon section) is integrated. Thereby, the connecting distance from a semiconductor chip as a high frequency analog circuit is decreased, and the signal quality is able to be improved.

### SUMMARY OF THE INVENTION

However, in the interposer exemplified as above, there has been a disadvantage that its manufacturing steps such as jointing the silicon substrate provided with the antenna pattern and patterning the antenna section and the semiconductor chip section become complicated, and thus reliability and yield ratio are lowered.

In view of the foregoing disadvantage, in the invention, it is desirable to provide an interposer with which the manufacturing steps are able to be simplified, a module, and an electronics device including the same.

According to an embodiment of the invention, there is provided an interposer including a substrate having a front face and a rear face, a wiring that is formed on the front face side of the substrate and is electrically connected to a semiconductor chip, an electric device connected to the wiring, and a concave section that is formed from the rear face side of the substrate in a position corresponding to the electric device.

In this case, "concave section" includes a penetrating shape obtained by totally removing the substrate at the bottom part of the concave section, in addition to a shape in which the substrate remains at the bottom part of the concave section.
Further, "concave section that is formed from the rear face side of the substrate in a position corresponding to the electric device" means a state that the concave section is in a position above which at least part of the electric device provided on the substrate is provided.

According to an embodiment of the invention, there is provided a module including the interposer of the foregoing embodiment of the invention and a semiconductor chip mounted on the interposer

According to an embodiment of the invention, there is provided an electronics device including the interposer of the foregoing embodiment of the invention, a semiconductor chip mounted on the interposer, and a mount substrate on which the interposer is mounted.

In the interposer, the module, and the electronics device including the same of the embodiment of the invention, the wiring and the electric device are previously provided on the substrate. Thereby, joint between the substrate and the wiring, patterning of the electric device such as an antenna and the semiconductor chip and the like are not necessitated. Accordingly, the manufacturing steps are simplified.

In the interposer, the module, and the electronics device including the same of the embodiment of the invention, the wiring and the electric device are provided on the substrate. Thus, the manufacturing steps are simplified. Thereby, reliability and yield ratio are able to be improved.

Other and further objects, features and advantages of the invention will appear more fully from the following description.

### BRIEF DESCRIPTION OF THE DRAWINGS

FIG. 1 is a cross sectional view of a module according to an embodiment of the invention.

FIG. 2 is a planar view of the module illustrated in FIG. 1.

FIG. 3 is a cross sectional view illustrating a module of another example.

FIGs. 4A and 4B are characteristics diagrams of radio emission of the module illustrated in FIG. 1.

FIGs. 5A to 5C are views illustrating a method of manufacturing the module illustrated in FIG. 1 in order of steps.

FIGs. 6A to 6C are views illustrating steps following FIGs. 5A to 5C.

FIG. 7 is a cross sectional view of a module according to a comparative example.

FIGs. 8A to 8C are views illustrating a method of manufacturing the module illustrated in FIG. 7 in order of steps.

FIGs. 9A to 9C are views illustrating steps following FIGs. 8A to 8C.

FIGs. 10A to 10B are views illustrating steps following FIGs. 9A to 9C.

FIG. 11 is a cross sectional view of a module according to a modified example.

FIG. 12 illustrates a planar view of the module illustrated in FIG. 11.

FIG. 13 is a cross sectional view illustrating a module of another example.

FIG. 14 is a functional block diagram of an electronics device according to an application example of the module.

### DETAILED DESCRIPTION OF THE PREFERRED EMBODIMENT

An embodiment of the invention will be hereinafter described with reference to the drawings in the following order:
(1) Whole structure
(2) Manufacturing method

(1) Whole structure

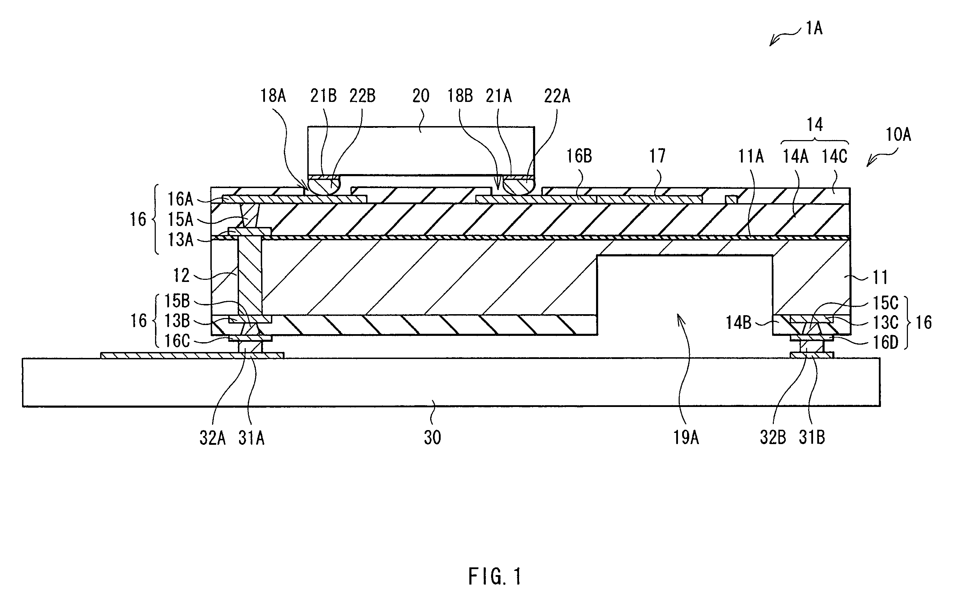

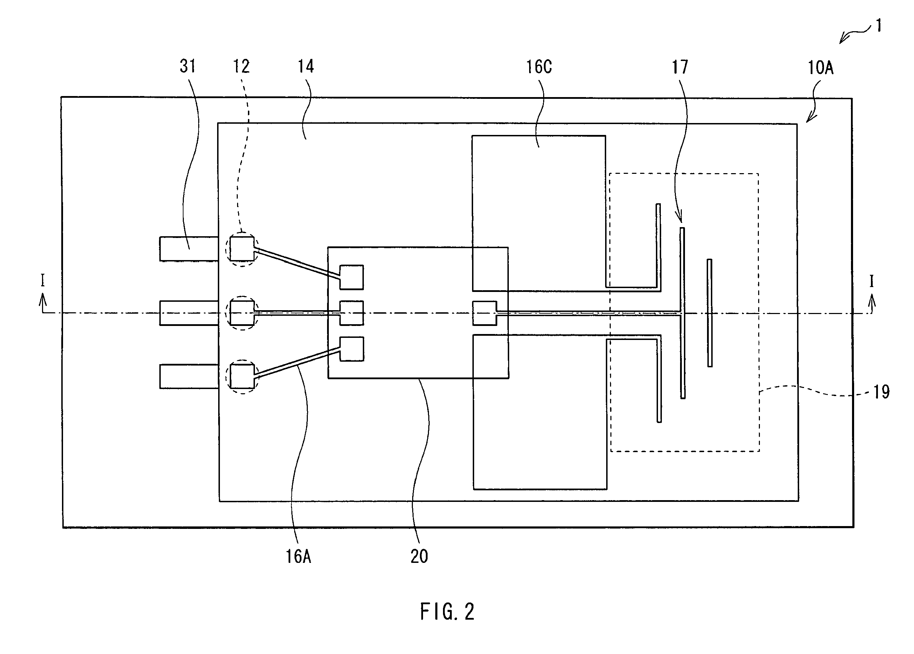

FIG. 1 illustrates a cross sectional structure of a module 1A including an interposer 10A and a semiconductor chip 20 according to an embodiment of the invention. FIG. 2 illustrates a planar structure thereof. FIG. 1 is a cross sectional structure taken along line I-I of FIG. 2. In the interposer 10A, a dielectric layer 14 is formed on a substrate 11 including a concave section 19A. In the dielectric layer 14, a wiring layer 16 and an electric device 17 (in this case, an antenna) are provided. Above the dielectric layer 14, the semiconductor chip 20 connected to a wiring layer 16 is provided. The interposer 10A connects the semiconductor chip 20 to a mount substrate 30 (in this case, a printed board) with a penetrating electrode 12 provided in the substrate 11 in between.

As the substrate 11, for example, a silicon (Si) substrate or a silicon carbide (SiC) substrate having a thickness from 50 to 400 µm both inclusive is desirably used to match with a material of the semiconductor chip 20 described later. By matching with the material of the semiconductor chip 20, each thermal expansion coefficient becomes almost identical, and reliability of joint between the semiconductor chip 20 and the interposer 10A is thereby improved. A material of the substrate 11 is not limited thereto, but other semiconductor material or a dielectric material may be used. Examples of other semiconductor materials include SiGe and GaAs. Examples of dielectric materials include ceramic, glass (for example, Pyrex, SD2, and quartz), a resin (glass epoxy and BT resin), and an organic polymer.

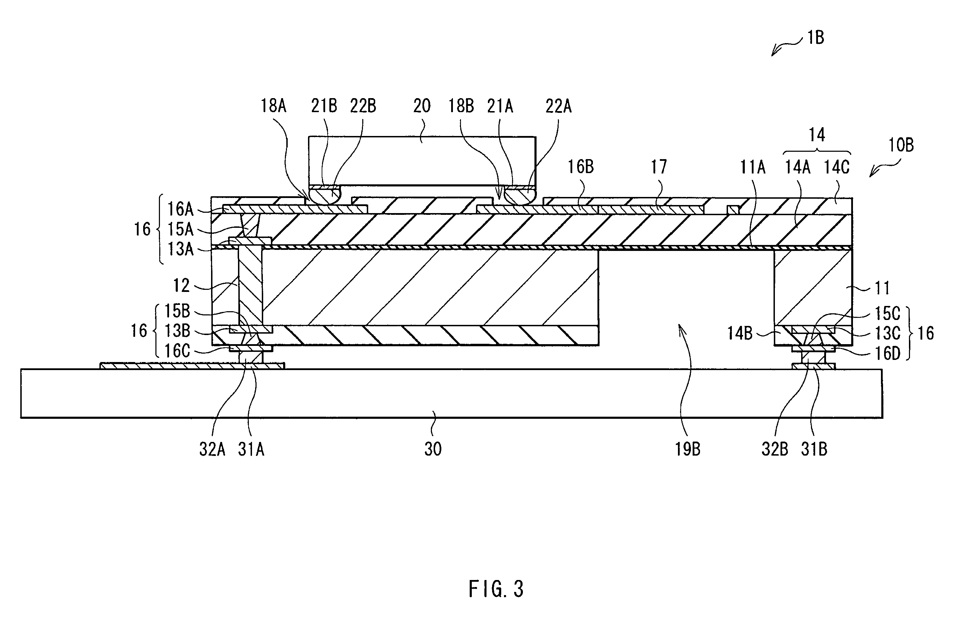

The substrate 11 is provided with the concave section 19A having a pit on the rear face side of the substrate 11 in a position corresponding to at least part of the antenna 17 provided in the dielectric layer 14. In view of relation with inhibiting effect of signal loss, the concave section 19A is desirably formed in a position opposed to the antenna 17 described later, that is, is desirably formed to cover the entire antenna 17 in the overhead view as illustrated in FIG. 2. In this case, the substrate 11 remains at the bottom part of the concave section 19A. However, the substrate 11 does not necessarily remain at the bottom part of the concave section 19A, but a penetrating aperture 19B formed by totally removing the substrate 11 may be adopted as illustrated in FIG. 3. Further, it is possible that the substrate 11 is not totally removed, but part thereof remains. Specifically, the concave section 19A may be formed in a palisade state or in a lattice pattern. Further, the planar pattern of the concave section 19A (aperture 19B) is, for example, circular or rectangle. However, the planar pattern of the concave section 19A (aperture 19B) is not limited thereto, but is determined by relation with the shape and the size of an electric device arranged above the concave section 19A (aperture 19B).

Further, the substrate 11 includes the penetrating electrode 12 having a diameter of 50 µm, for example. The penetrating electrode 12 is formed from, for example, copper (Cu). Pads 13A and 13B are provided above and below the penetrating electrode 12.

An insulating layer 11A is provided between the substrate 11 and the dielectric layer 14. In the insulating layer 11A, for example, a silicon nitride film (SiN) having a thickness, for example, from 0.01 to 0.3 µm both inclusive is formed on a silicon oxide film (SiO₂) having a thickness, for example, from 0.01 to 4 µm both inclusive. As will be described later, the insulting layer 11A functions as an etching stopper layer in providing the concave section 19A (aperture 19B) in the substrate 11. However, the insulating layer 11A is dispensable as a structure for attaining performance of a so-called membrane device having the concave section 19A (aperture 19B) such as the interposer 10A of this embodiment.

The dielectric layer 14 is formed from a low dielectric constant material with small loss for a high frequency signal such as benzocyclobutene (BCB). The thickness of the dielectric layer 14 is determined by both electric characteristics and mechanical strength, and is, for example, from 1 µm to 20 µm both inclusive. However, an optimal film thickness of the dielectric layer 14 varies according to the wiring layout rule. For example, for electric characteristics requisite, the film thickness range is determined by viewpoint of wiring impedance matching. Specifically, for example, in the case of 50 Ω matching under the condition of wiring of 60 GHz, high frequency wiring with line/space of 50 µm/50 µm, and micro strip line, a film thickness of 20 µm is necessitated. Further, considering line/space corresponding to a pad of a CMOS (Complementary Metal Oxide Semiconductor) in which narrow pitch and multiple pin are accelerated, 50 Ω matching is obtained in the case where the thickness is 12 µm when line/space is 30 µm/30 µm, the thickness is 6 µm when line/space is 15 µm/15 µm, and the thickness is 3 µm when line/space is 5 µm/5 µm. Thus, the dielectric layer 14 is desirably manufactured by technique of forming a BCB film including a thin film of several µm or less to a thick film of several ten µm and a multilayer film technique. Further, as the dielectric layer 14, other material out of the generally used dielectric materials is able to be used, as long as such a material has small loss for a high frequency signal and has a strength to the degree with which a bridge structure is able to be retained even if the concave section 19A (aperture 19B) is provided in the substrate 11 as described above. Specifically, in addition to an inorganic material such as SiO₂, diamond-like carbon (DLC) is able to be used.

In the dielectric layer 14, the wiring layer 16 and the antenna 17 are provided. The wiring layer 16 is composed of a combination of at least one or more multilayer wiring layers (in this case, one layer: wirings 16A and 16B) and an interlayer connection wiring layer (via contact 15A). The wiring layer 16 is made of a conductive material, for example, a metal material such as Al (aluminum) and AlCu (aluminum copper). In this case, the antenna 17 is an artificial Yagi antenna made of an Al wiring. It is needless to say that the device is not limited thereto, but other passive device such as a patch antenna and a slot antenna may be used. Further, a metal material other than Al may be used. To secure signal quality, the antenna 17 and the after-mentioned semiconductor chip 20 are desirably arranged in the proximity of each other. By decreasing the distance between the antenna 17 and the semiconductor chip 20, accumulated loss of the transmitting and receiving circuit is able to be decreased. For example, in the case where the semiconductor chip 20 and the antenna 17 are connected through a wire, for example, a gold (Au) wire being about 1.5 mm long having a diameter of 20 µm has 0.8 nH parasitic inductance, and signal loss of about 1 dB is generated in 60GHz. Meanwhile, in the case where the antenna 17 and the semiconductor chip 20 are arranged as in this embodiment, the distance between the antenna 17 and the semiconductor chip 20 becomes 200 µm, and signal loss is largely decreased down to 0.1 dB. Further, by forming the antenna 17 above the concave section 19A (aperture 19B) as described above, signal loss caused by the substrate is decreased, and a higher antenna gain is obtained. As illustrated in FIG. 1, FIG. 3, and FIGs. 5A, 5B, and 5C, the interlayer connection wiring layer is obtained by forming a through hole 14a in the dielectric layer 14A and filling the through hole 14a with a metal material. However, the form of the interlayer connection wiring layer is not limited thereto, and any shape is able to be adopted as long as wiring in different layers are connected to each other.

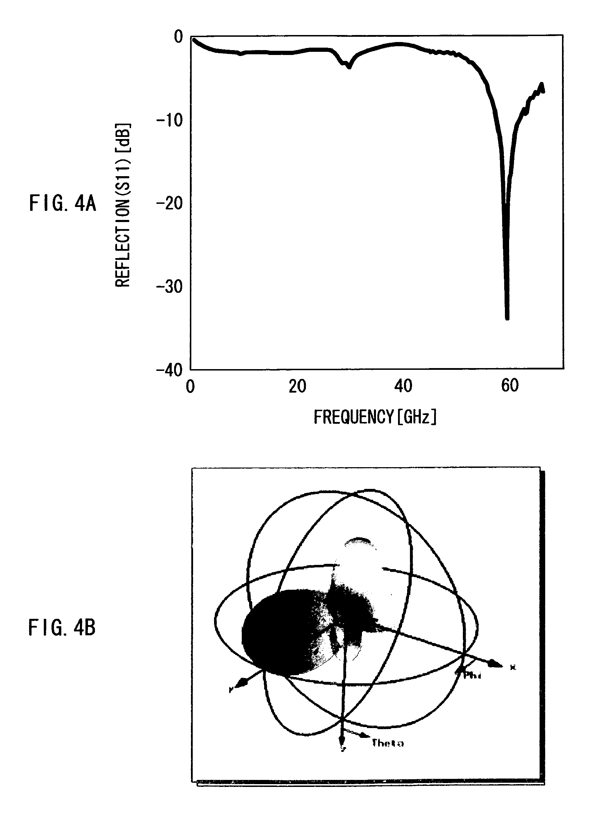

FIG. 4A illustrates characteristics of reflectance characteristics (S11) of an artistic Yagi antenna with central frequency of 60 GHz. FIG. 4B illustrates calculation result of radio emission characteristics of far field (three dimensional illustration). In the main lobe in the emission characteristics, the calculation result of the antenna gain of the membrane antenna is -5dBi, while the calculation result of the reference antenna that is not the membrane antenna is -10dBi. Accordingly, a high antenna gain is able to be obtained by providing the concave section 19A (aperture 19B) in a position opposed to the antenna 17 as in this embodiment.

The semiconductor chip 20 is RFIC. In this case, the semiconductor chip 20 is a device that up-converts a signal in several hundred MHz band inputted from, for example, a base band chip to a signal in high frequency band as a signal in milliwave band, for example. The semiconductor chip 20 is connected to the wirings 16A and 16B with pads 21A and 21B and solder layers 22A and 22B in between. The wiring 16A is connected to the penetrating electrode 12 with the via 15A and the pad 13A in between. Meanwhile, the wiring 16B is connected to the antenna 17.

The printed board 30 is a mount substrate on which many electronic parts such as a resistor and a condenser in addition to the module 1A (1B) are mounted, and configures an electronic circuit by connecting these electronic parts to each other by wiring.

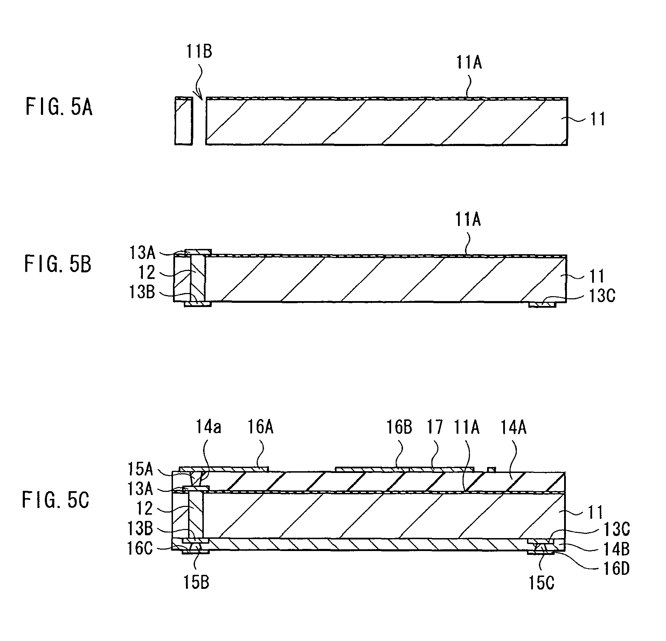

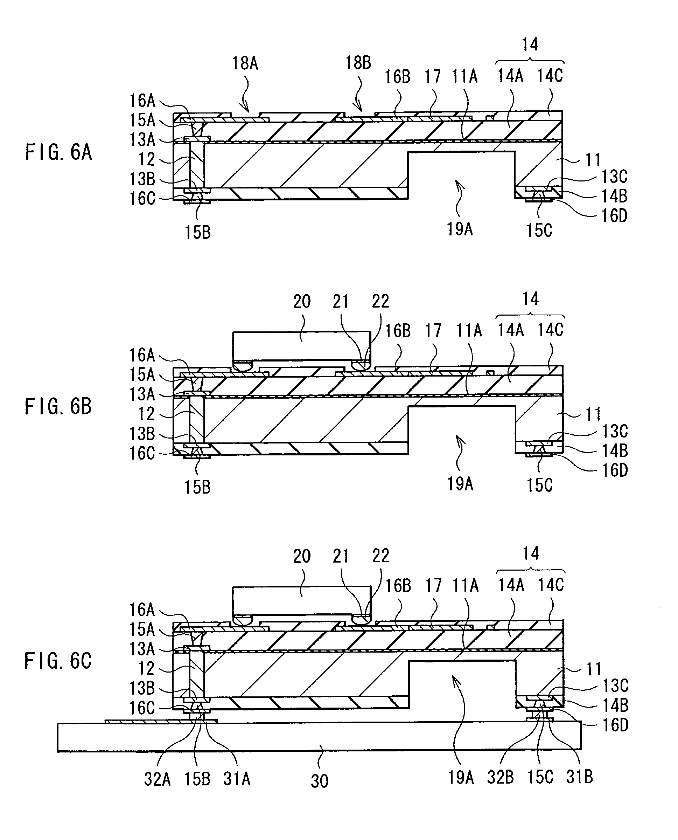

The module 1A (1B) may be manufactured, for example, by the method illustrated in FIGs. 5A to 5C and FIGs. 6A to 6C.

(2) Manufacturing method

First, as illustrated in FIG. 5A, after a through hole 11B is formed in the substrate 11, the insulating layer 11A is formed. Specifically, an etching mask is patterned on the front face of the substrate 11 having a thickness of, for example, 400 µm. Next, the substrate 11 is etched in the thickness direction under vacuum condition by using a DRIE (Deep Reactive Ion Etching) apparatus to form the through hole 11B. Subsequently, the substrate 11 is heated at, for example, 1000 deg C to form an SiO₂ film having a thickness of 3 µm by thermal oxidation under water vapor atmosphere. Next, on the SiO₂ film on the front face of the substrate 11, a SiN film having a thickness from 0.1 to 0.3 µm both inclusive is formed by, for example, CVD (Chemical Vapor Deposition) method to obtain the insulating film 11A.

Subsequently, the penetrating electrode 12 is formed as illustrated in FIG. 5B. Specifically, for example, as a seed layer (not illustrated), on the surface of the through hole 11B, base titanium (Ti) having a thickness of, for example, 50 nm and a copper (Cu) thin film having a thickness of, for example, 300 nm were formed by, for example, PVD (Physical Vapor Deposition). Next, after the through hole 11B is filled with Cu by electrolytic copper plating, the substrate 11 is polished by CMP (Chemical Mechanical Polishing) to form the penetrating electrode 12. Subsequently, as the pad 13A, the pad 13B, and a pad 13C, an AlCu thin film having, for example, a diameter of 100 µm and a thickness of 100 nm is formed by, for example, photolithography and dry etching such as DRIE.

Next as illustrated in FIG. 5C, the dielectric layer 14A, the via contact 15A, the wirings 16A and 16B, and the antenna 17 are formed. Specifically, first, on the top face of the substrate 11, the dielectric layer 14A is formed by spin coat method with the use of BCB as a low dielectric constant material. The through hole 14a that reaches the pad 13A is formed in the dielectric layer 14A. After that, the through hole 14a is filled with AlCu to form the via contact 15A. Next, on the dielectric layer 14A, the wirings 16A and 16B and the antenna 17 are formed by photolithography and dry etching. Next, by using a similar method, a dielectric layer 14C, via contacts 15B and 15C, and pads 16C and 16D are formed on the bottom face of the substrate 11.

Subsequently, as illustrated in FIG. 6A, after the dielectric layer 14C is formed on the top face of the substrate 11, apertures 18A and 18B for connecting the semiconductor chip 20 with the wirings 16A and 16B are formed. Specifically, after the dielectric layer 14C is formed on the top face of the substrate 11 by spin coat method by using, for example, BCB, the dielectric layer 14C in a region on which the semiconductor chip 20 is mounted is removed by photolithography and dry etching. Next, for example, a hard mask is formed on the bottom face of the substrate 11. After that, the substrate 11 is etched by, for example, DRIE to form the concave section 19A (aperture 19B) and complete the interposer 10A having a desired membrane structure. As etching conditions, vertical process by SF₆/C₄H₈ known as Bosch process or dry process by XeF₂ is used. Further, wet process using tetramethylammonium hydroxide (TMAH) or potassium hydroxide (KOH) may be used. At this time, since the insulating layer 11A provided between the substrate 11 and the dielectric layer 14 works as an etching stopper layer, etching is stopped in the insulating layer 11A. In the case where the thickness of the insulating layer 11A is small, overetching may be generated.

Next, as illustrated in FIG. 6B, the semiconductor chip 20 is mounted on the top face of the interposer 10A. Specifically, the pads 21A and 21B provided on the bottom face of the semiconductor chip 20 are thermally compression-bonded with the top face of the interposer 10A, for example, at 150 deg C and 100 kPa. Accordingly, joint between the semiconductor chip 20 and the interposer 10A is completed.

Finally, as illustrated in FIG. 6C, the pads 16C and 16D of the interposer 10A are connected with pads 31A and 31B formed on the printed board 30 with bumps 32A and 32B in between, and the interposer 10A on which the semiconductor chip 20 is provided is mounted on the printed board 30. Thereby, the module 1A is completed.

In the interposer 10A (10B) of this embodiment, the dielectric layer 14 is formed on the substrate 11, and the wiring layer 16 and the antenna 17 are included in the dielectric layer 14. Further, the penetrating electrode 12 is provided in the substrate 11. The interposer 10A connects the printed board 30 and the semiconductor chip 20 provided on the interposer 10A with the penetrating electrode 12 in between. As described above, by using the interposer 10A, the semiconductor chip 20 and the printed board 30 with each wiring pitch different from each other are able to be relayed electrically and mechanically.

Further, in the position corresponding to the antenna 17 of the substrate 11, the concave section 19A (aperture 19B) formed from the rear face side of the substrate 11 is provided. Thereby, parasitic capacity and eddy current between the substrate 11 and the antenna 17 are inhibited.

As described above, the semiconductor chip 20 and the printed board 30 are connected based on a narrow wiring pitch in the connection section on the semiconductor chip 20 side and based on a wide wiring pitch in the connection section on the printed board 30 side. The pads composing the connection section and wirings for their connection are the wiring layer 16 provided in the dielectric layer 14 on the substrate 11 of the interposer 10A, the penetrating electrode 12, and the wiring layer 16 (the pads 13B and 16C and the via contact 15B) on the rear face side of the substrate 11. Their lines and spaces are formed by using a processing means of the semiconductor chip. Thus, compared to a general mount substrate, processing is made by a single-digit or more refined processing technology or based on a rule equal to a wiring processing rule of semiconductor chips. The wiring layer 16 (the pads 13C and 16D and the via contact 15C) on the right side of the rear face side of the substrate 11 of the interposer 10A (10B) in FIG. 1 (FIG. 3) is a dummy connection layer for achieving the mechanical balance in mounting on the printed board 30 or a GND (ground) connection layer of the substrate 11.

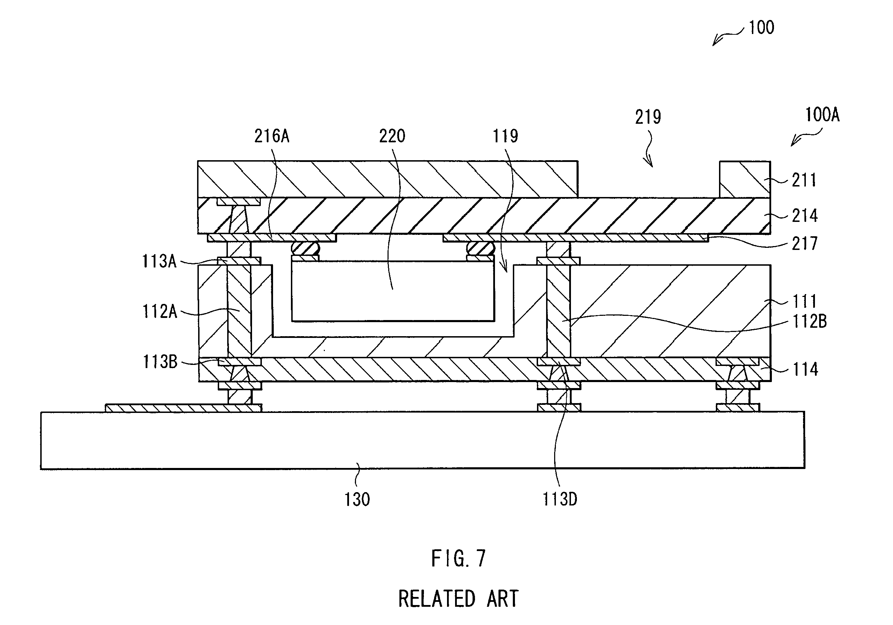

FIG. 7 illustrates a cross sectional structure of an existing module 100 according to a comparative example. In an interposer 100A in the module, a second Si substrate 211 that has a wiring 216A and an antenna 217 on the bottom face and has a semiconductor chip (integrated circuit chip) 220 is jointed to a first Si substrate (interposer) 111 that has a concave section 119 by a joint metal. The concave section 119 is intended to contain the semiconductor chip 220.

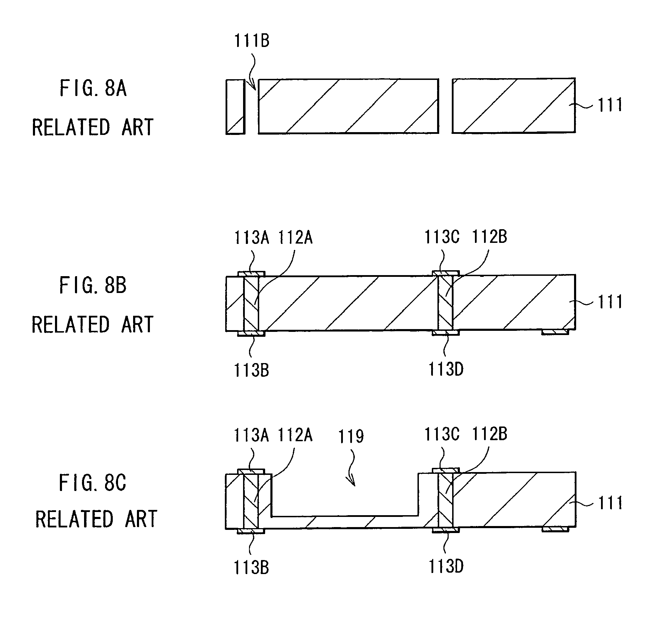

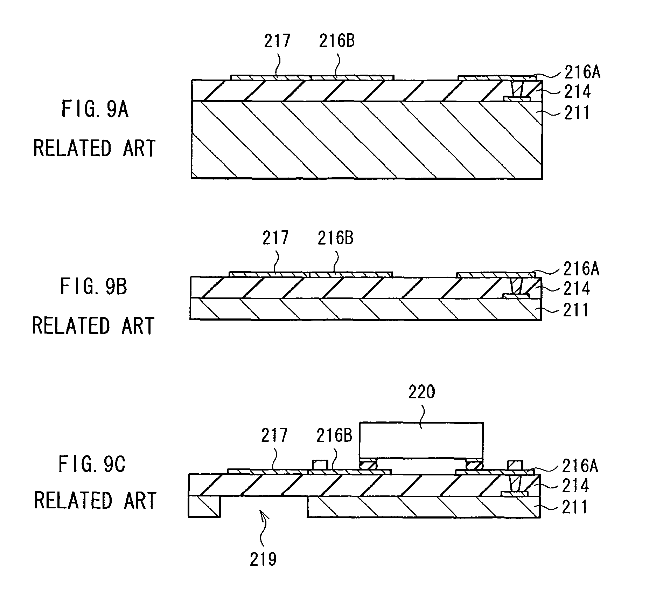

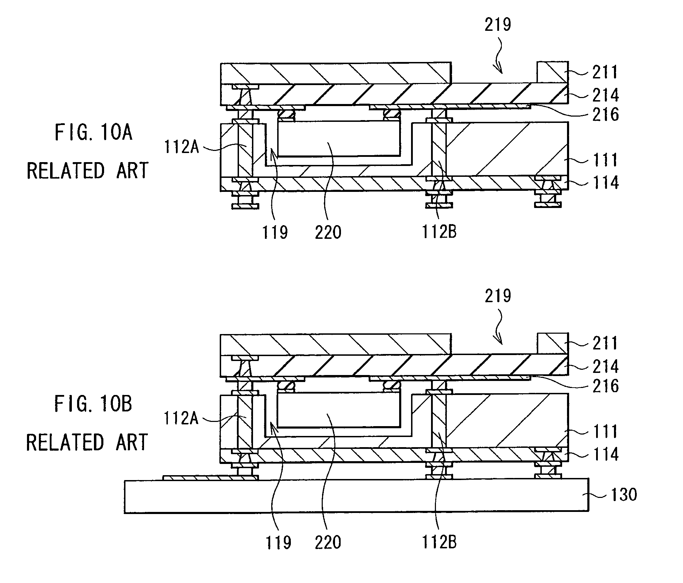

To practically obtain such a module 100, the manufacturing steps illustrated in FIGs. 8A to 8C, FIGs. 9A to 9C, and FIGs. 10A to 10B may be used. Each step thereof will be hereinafter described in short. First, as illustrated in FIG. 8A, the first Si substrate 111 is processed to form a through hole 111B. After that, an insulating film (not illustrated) is formed. Next, as illustrated in FIG. 8B, after a penetrating electrode 112A is formed, pads 113A, 113B, 113C, and 113D are formed. Subsequently, as illustrated in FIG. 8C, the concave section 119 is formed, and the first Si substrate 111 to become the interposer is formed. Next, as illustrated in FIG. 9A, a dielectric layer 214 including wiring 216A and 216B and the antenna 217 is formed on the second Si substrate 211. After that, as illustrated in FIG. 9B, the second Si substrate 211 is processed into a thin film by CMP. Subsequently, as illustrated in FIG. 9C, a concave section 219 is provided in the second Si substrate 211 to obtain a membrane structure. After that, the semiconductor chip 220 is connected, and the second Si substrate 211 on which the semiconductor chip 220 is provided is formed. Next, as illustrated in FIG. 10A, the first Si substrate 111 and the second Si substrate 211 are jointed by thermal compression bonding. After that, finally, as illustrated in FIG. 10B, the resultant is mounted on a printed board 130 by using solder to complete the module 100.

There is the following disadvantage in the module 100 obtained as above and the manufacturing steps thereof. First, since two Si substrates are used, the module size is naturally increased. Thus, to compensate for such an increased size, a step of obtaining a thin film (FIG. 9B) is necessitated. Further, in addition to forming the concave section 119 in the first Si substrate 111, it is necessary to provide the concave section 219 in a position opposed to the antenna 217 of the second Si substrate 211 for radio emission from the antenna 217. At this time, since the second Si substrate 211 is processed into a thin film as described above, there is a possibility that the second Si substrate 211 is easily broken. Further, in mounting the second Si substrate 211 on the first Si substrate 111, penetrating electrodes 112A and 112B of the first Si substrate 111 are jointed to the wiring layer 216 provided on the bottom face of the second Si substrate 211. Since alignment precision of the joint step is low, it leads to restriction of miniaturization. In addition, in the case where transmission frequency is high, signal loss due to wiring mismatch or the like is shown. Further, wiring step for jointing the first Si substrate 111 to the second Si substrate 211 is necessitated. As described above, the manufacturing steps become complicated.

Meanwhile, in the interposer 10A (10B) of this embodiment, since the wiring layer 16 is provided in the dielectric layer 14 that is directly formed on the substrate 11, the foregoing steps are not necessitated. Thus, the manufacturing steps are able to be simplified.

As described above, in the interposer 10A (10B) and the module 1A (1B) including the same of this embodiment, the dielectric layer 14 is formed on the substrate 11, and the wiring layer 16 and the antenna 17 are provide in the dielectric layer 14. By integrating the substrate 11 and the wiring layer 16, the manufacturing steps are simplified, and the yield ratio is able to be improved.

Further, since the joint step that causes lowering of alignment precision is eliminated, characteristics of the module 1A (1B) are improved. Further, since the manufacturing steps are reduced, the cost is able to be reduced.

Further, since the semiconductor chip 20 and the printed board 30 are connected with the penetrating electrode 12 in between, the wiring area is able to be reduced. That is, the size of the module 1A (1B) is able to be decreased. Further, by using the penetrating electrode 12, other module is able to be layered on the module 1A (1B).

Further, in the interposer 10A (10B) and the module 1A (1B) including the same of this embodiment, the concave section 19A (or the aperture 19B penetrating the substrate 11) is provided on the rear face side of the substrate 11 in a position corresponding to at least part of the antenna 17. Thereby, parasitic capacity and eddy current between the substrate and the device are inhibited. Accordingly, signal loss is able to be inhibited.

### Modified example

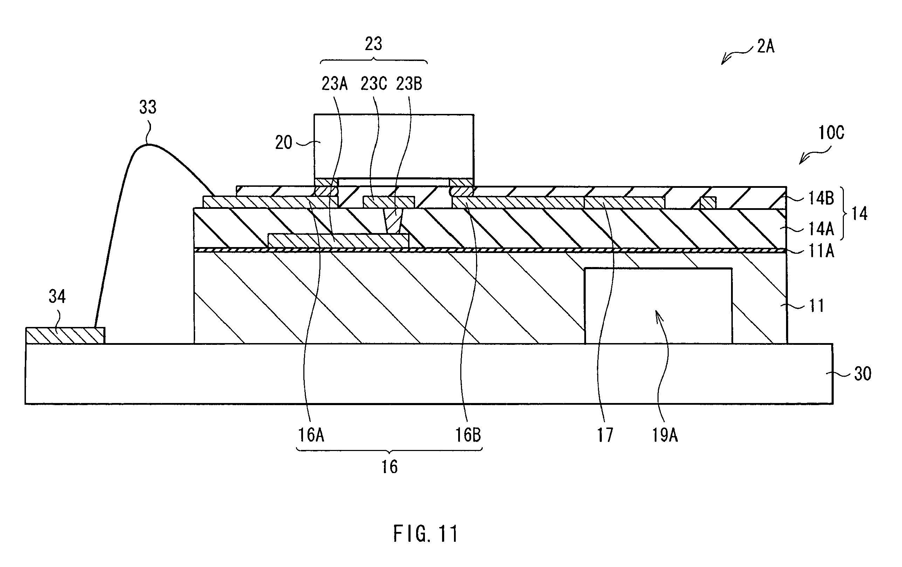

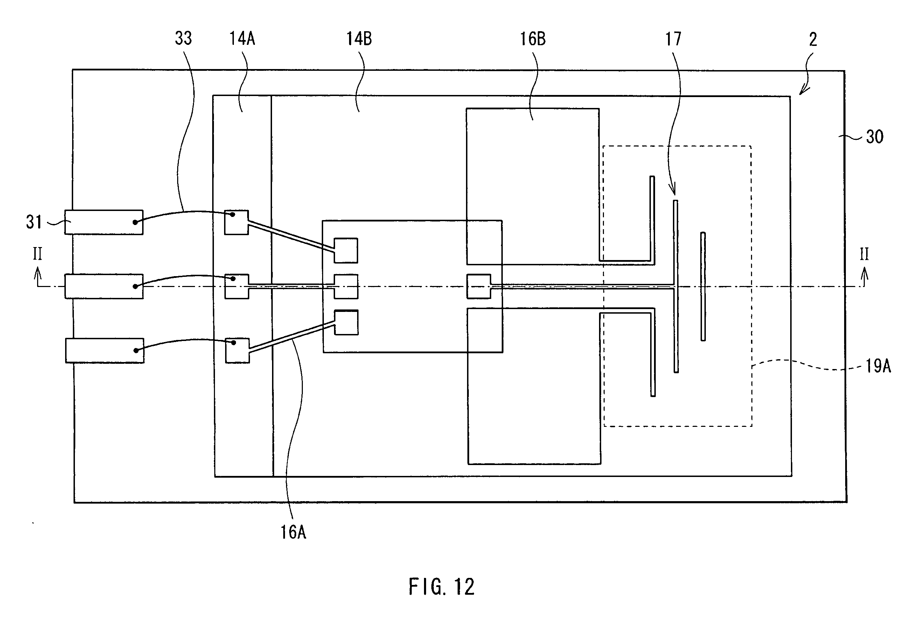

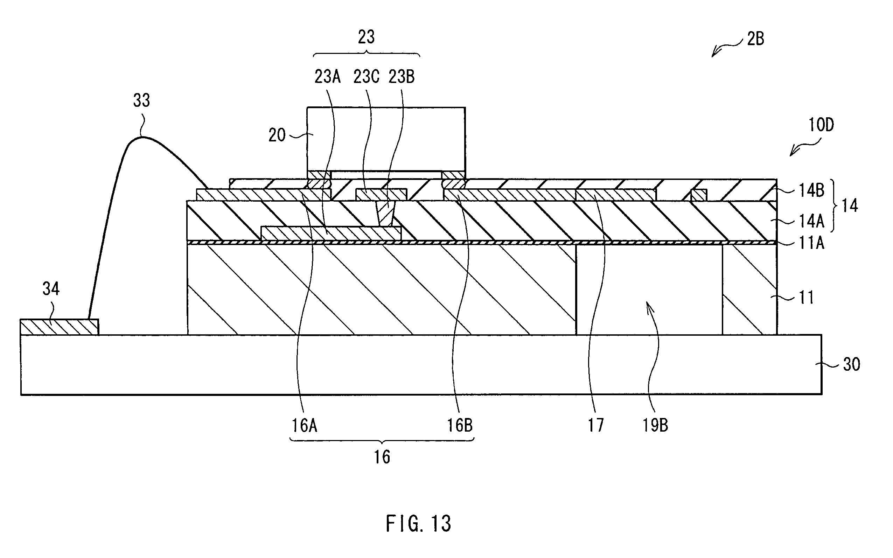

Next, a description will be given of an interposer 10C (10D) and a module 2A (2B) including the same according to a modified example of the interposer 10A (10B) and the module 1A (1B) including the same according to the foregoing embodiment. FIG. 11 illustrates a cross sectional structure of the module 2A including the interposer 10C having the concave section 19A in the substrate 11, and FIG. 12 illustrates a planar structure thereof. FIG. 13 illustrates a cross sectional structure of the module 2B including the interposer 10D having the aperture 19B in the substrate 11. FIG. 11 and FIG. 13 are a cross sectional structure taken along line II-II of FIG. 12. For the same elements as those of the first embodiment, the same referential symbols are affixed thereto and the descriptions thereof will be omitted.

The interposer 10C (10D) connects the wiring layer 16 to the printed board 30 with a wiring 33. On the substrate 11, a chip-use connection section 23 is provided together with a wire pad for wire connection with the printed board 30 and a decoupling condenser (MIM capacitor) (not illustrated) for removing wiring noise is provided, in addition to the dielectric layer 14 in which the wiring layer 16 and the electric device 17 described in the foregoing embodiment are formed.

In the interposer 10C (10D) and the module 2A (2B) including the same of this modified example, the wiring layer 16 and the printed board 30 are connected by the wiring 33. Thus, there is an effect that the module 2A (2B) is able to be freely arranged on the printed board 30 in addition to the effect of the foregoing embodiment. Further, in the case where the number of pins is small and device occupied area difference is smaller than in a BGA (Ball Grid Array) or the like, it is more inexpensive to adopt wiring by the wire 33 than manufacturing the penetrating electrode 12. Thus, there is an effect that the cost is able to be reduced.

### Application example

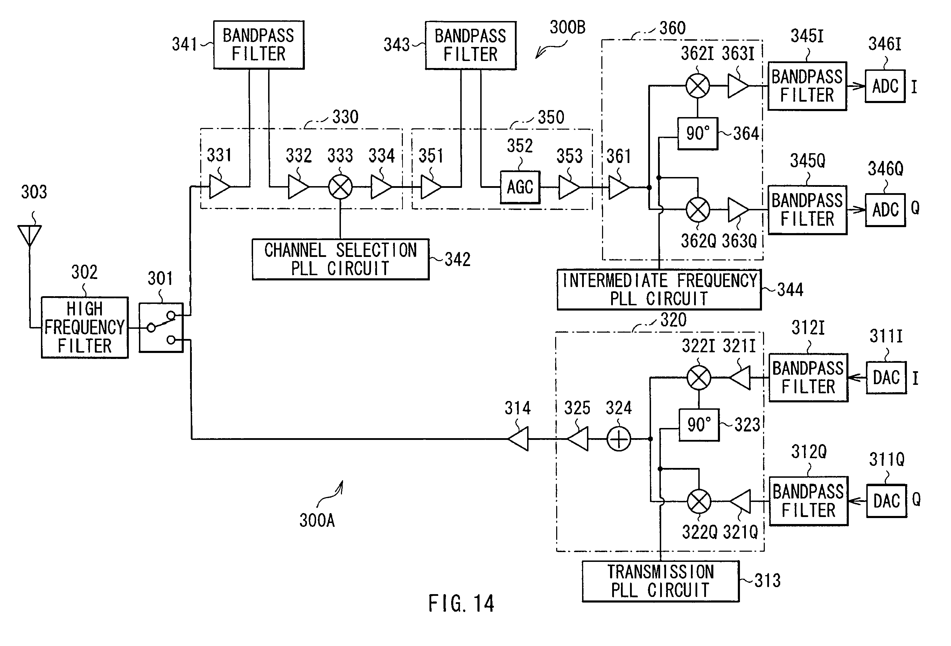

Next, a description will be given with reference to FIG. 14 of a configuration of a communication apparatus in which the interposer 10A of the embodiment of the invention is used. FIG. 14 illustrates a block configuration of the communication apparatus as an electronics device.

Examples of the communication apparatus illustrated in FIG. 14 include a mobile phone, a personal digital assistant (PDA), and a wireless LAN apparatus. For example, as illustrated in FIG. 14, the communication apparatus includes a transmission circuit 300A (module), a receiving circuit 300B (module), a transmitting/receiving switch 301 for switching the transmitting/receiving route, a high frequency filter 302, and a transmitting/receiving antenna 303.

The transmission circuit 300A includes two digital/analog converters (DAC) 311I and 311 Q, and two bandpass filters 312I and 312Q that respectively correspond to transmission data of I channel and transmission data of Q channel, a modulator 320, a transmission PLL (Phase-Locked Loop) circuit 313, and a power amplifier 314. The modulator 320 includes two buffer amplifiers 321I and 321Q and two mixers 322I and 322Q that respectively correspond to the foregoing two bandpass filters 312I and 312Q, a phase module 323, an adder 324, and a buffer amplifier 325.

The receiving circuit 300B includes a high frequency section 330, a bandpass filter 341, a channel selection PLL circuit 342, an intermediate frequency circuit 350, a bandpass filter 343, a demodulator 360, an intermediate frequency PLL circuit 344, two bandpass filters 345I and 345Q and two analog/digital converters (ADC) 346I and 346Q that respectively correspond to receiving data of I channel and receiving data of Q channel. The high frequency section 330 includes a low noise amplifier 331, buffer amplifiers 332 and 334, and a mixer 333. The intermediate frequency circuit 350 includes buffer amplifiers 351 and 353 and an Auto Gain Controller (AGC) circuit 352. The modulator 360 includes a buffer amplifier 361, two mixers 362I and 362Q and two buffer amplifiers 363I and 363Q that respectively correspond to the foregoing two bandpass filters 345I and 345Q, and a phase module 364.

In the communication apparatus, in the case where transmission data of the I channel and transmission data of the Q channel is inputted to the transmission circuit 300A, each transmission data is processed in the following procedure. That is, first, the transmission data is converted to an analog signal in the DAC 311I and 311Q. Subsequently, signal components other than the band of the transmission signal are removed in the bandpass filters 312I and 312Q, and then the resultant signal is supplied to the modulator 320. Subsequently, in the modulator 320, the signal is supplied to the mixers 322I and 322Q via the buffer amplifiers 321I and 321Q, the resultant signal is mixed with a frequency signal corresponding to the transmission frequency supplied from the transmission PLL circuit 313, and then modulated. After that, both mixed signals are added in the adder 324, and thereby one system transmission signal is obtained. At this time, for the frequency signal supplied to the mixer 322I, the signal phase is shifted 90 degrees in the phase module 323. Thereby, the I channel signal and the Q channel signal are modulated orthogonal to each other. Finally, the signal is supplied to the power amplifier 314 via the buffer amplifier 325. Thereby, the signal is amplified to obtain a given transmission power. The signal amplified in the power amplifier 314 is supplied to the antenna 303 via the transmitting/receiving switch 301 and the high frequency filter 302, and thereby is wireless-transmitted via the antenna 303. The high frequency filter 302 functions as a bandpass filter for removing signal components other than the frequency band out of a transmitted or received signal in the communication apparatus.

Meanwhile, in the case where a signal is received by the receiving circuit 300B from the antenna 303 via the high frequency filter 302 and the transmitting/receiving switch 301, the signal is processed in the following procedure. That is, first, in the high frequency section 330, the received signal is amplified in the low noise amplifier 331. Subsequently, signal components other than the receiving frequency band are removed by the bandpass filter 341. After that, the signal is supplied to the mixer 333 via the buffer amplifier 332. Subsequently, the signal is mixed with a frequency signal supplied from the channel selection PPL circuit 342, and a given transmission channel signal is set as an intermediate frequency signal. Thereby, the signal is supplied to the intermediate frequency circuit 350 via the buffer amplifier 334. Subsequently, in the intermediate frequency circuit 350, the signal is supplied to the bandpass filter 343 via the buffer amplifier 351. Thereby, signal components other than the band of the intermediate frequency signal are removed. The resultant signal subsequently becomes an almost constant gain signal in the AGC circuit 352. After that, the signal is supplied to the demodulator 360 via the buffer amplifier 353. Subsequently, in the demodulator 360, the signal is supplied to the mixers 362I and 362Q via the buffer amplifier 361. After that, the signal is mixed with a frequency signal supplied from the intermediate frequency PPL circuit 344. The I channel signal component and the Q channel signal component are demodulated. At this time, for the frequency signal supplied to the mixer 362I, the signal phase is shifted 90 degrees in the phase module 364. Thereby, the I channel signal component and the Q channel signal component that are modulated perpendicular to each other are demodulated. Finally, the I channel signal and the Q channel signal are supplied to the bandpass filters 345I and 345Q, respectively, and thereby signal components other than the I channel signal and the Q channel signal are removed. After that, the signal is supplied to the ADC 346I and 346Q to obtain digital data. Thereby, I channel receiving data and Q channel receiving data are obtained.

In the communication apparatus, the interposers 10A to 10D described in the foregoing embodiment and the foregoing modified example are applied to connect the antenna 303, the high frequency filter 302, the bandpass filters 341 and 343, the modulator 320, and the demodulator 360 to the mount substrate. Thus, due to the action described in the foregoing embodiment, superior high frequency characteristics are obtained.

In the communication apparatus illustrated in FIG. 14, the description has been given of the case that the interposers 10A to 10D described in the foregoing embodiment and the foregoing modified example are applied to the connection between the foregoing respective elements and the mount substrate. However, application is not always limited thereto. For example, the interposers 10A to 10D may be applied to the wiring connection in an integrated device composed of a CMOS device and an MEMS sensor with each miniaturization different from each other. In this case, effect similar to the foregoing effect is able to be obtained as well. Further, the interposers 10A to 10D are able to be applied to the integration of an analog circuit device and a digital circuit device.

While the invention has been described with reference to the embodiment and the modified example, the invention is not limited to the foregoing embodiment and the like, and various modifications may be made. For example, in the foregoing embodiment, the penetrating electrode 12 is used for connecting the semiconductor chip 20 to the printer substrate 30. However, if connection is made by a through-hole wiring, similar effect is obtained.

Further, in the foregoing embodiment and the like, the antenna 17 is used as an electric device (passive device). However, the device is not limited thereto, but an inductor or a coupler may be used. Further, an electric device other than the passive device such as a high frequency switch and a varicap diode used as a coupling condenser of a high frequency transmission line, or a filter or a variable filter combined with an electric device may be used.

The present application contains subject matter related to that disclosed in Japanese Priority Patent Application JP 2009-184674 filed in the Japan Patent Office on August 7, 2009 and Japanese Priority Patent Application JP 2010-130266 filed in the Japan Patent Office on June 7, 2010, the entire contents of which is hereby incorporated by references.

It should be understood by those skilled in the art that various modifications, combinations, sub-combinations and alternations may occur depending on design requirements and other factors insofar as they are within the scope of the appended claims or the equivalents thereof.

## Claims

1. An interposer comprising:
a substrate having a front face and a rear face;
a wiring that is formed on the front face side of the substrate and is electrically connected to a semiconductor chip;
an electric device connected to the wiring; and
a concave section that is formed from the rear face side of the substrate in a position corresponding to the electric device.

2. The interposer according to claim 1, wherein the electric device is a passive device.

3. The interposer according to claim 2, wherein the passive device is an antenna, an inductor, or a coupler

4. The interposer according to any one of claims 1 to 3, wherein a dielectric layer is provided on the substrate, and at least one layer of the wiring is provided in or on the dielectric layer.

5. The interposer according to claim 4, wherein the dielectric layer contains an organic material.

6. The interposer according to claim 4, wherein an insulating layer is provided between the substrate and the dielectric layer.

7. The interposer according to any one of claims 1 to 6, wherein a penetrating electrode connected to the wiring is provided in the substrate.

8. The interposer according to any one of claims 1 to 7, wherein the substrate is a semiconductor substrate or a dielectric substrate.

9. The interposer according to claim 8, wherein the substrate is a silicon substrate.

10. A module comprising:
an interposer; and
a semiconductor chip mounted on the interposer, wherein the interposer includes
a substrate having a front face and a rear face, in which the semiconductor chip is mounted on the front face side,
a wiring that is formed on the front face side of the substrate and is electrically connected to the semiconductor chip,
an electric device connected to the wiring, and
a concave section that is formed from the rear face side of the substrate in a position corresponding to the electric device.

11. The module according to claim 10, wherein the semiconductor chip is electrically connected to a mount substrate with the wiring and a penetrating electrode provided in the substrate in between.

12. An electronics device comprising:
an interposer;
a semiconductor chip mounted on the interposer; and
a mount substrate electrically connected to the interposer, wherein the interposer includes
a substrate having a front face and a rear face, in which the semiconductor chip is mounted on the front face side,
a wiring that is formed on the front face side of the substrate and is electrically connected to the semiconductor chip,
an electric device connected to the wiring, and
a concave section that is formed from the rear face side of the substrate in a position corresponding to the electric device.
